(19) **Europäisches Patentamt / European Patent Office / Office européen des brevets**

(11) **EP 2 378 704 B1**

(12) **EUROPÄISCHE PATENTSCHRIFT**

(45) Veröffentlichungstag und Bekanntmachung des Hinweises auf die Patenterteilung:
**19.09.2012 Patentblatt 2012/38**

(51) Int Cl.:
*H04L 7/04* *(2006.01)*  *H04J 3/04* *(2006.01)*
*H04J 3/06* *(2006.01)*  *H03M 9/00* *(2006.01)*

(21) Anmeldenummer: **10160015.3**

(22) Anmeldetag: **15.04.2010**

(54) **Verfahren zur Datenübertragung mit Rahmenbildung**

Method for data transmission with frame formation

Procédé de transmission de données à l'aide d'une formation de cadre

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**19.10.2011 Patentblatt 2011/42**

(73) Patentinhaber: **Albis Technologies AG**
**8047 Zürich (CH)**

(72) Erfinder: **Roland, Andreas**
**8057 Zürich (CH)**

(74) Vertreter: **Kley, Hansjörg et al**
**Siemens Schweiz AG**
**Intellectual Property**
**Freilagerstrasse 40**
**8047 Zürich (CH)**

(56) Entgegenhaltungen:
DE-A1- 2 529 995      JP-A- 4 124 931
US-A1- 2003 021 299    US-B1- 7 042 893

• WALKER R C ET AL: "A chipset for gigabit rate data communication (using optical fibres)" 19890918; 19890918 - 19890919, 18. September 1989 (1989-09-18), Seiten 288-290, XP010089337

**Beschreibung**

Die vorliegende Erfindung bezieht sich auf ein Verfahren zur Datenübertragung mit Rahmenbildung gemäss dem Oberbegriff des Patentanspruches 1 sowie auf ein Übertragungssystem zur Durchführung des Verfahrens.

Bei einer seriellen Datenübertragung ohne Phasenbezug zwischen Takt und übertragenen Daten stellt sich das Problem, die Daten zurückzugewinnen. Dieser fehlende Phasenbezug ergibt sich insbesondere bei Übertragungen über eine zum vorneherein nicht festgelegte oder festlegbare Leitungslänge.

Im Sinne eines Grenzwertes wird dieses Problem klassisch durch das das Nyquist-Shannonsche Abtasttheorem, in neuerer Literatur auch WKS-Abtasttheorem (für Whittaker-Kotelnikow-Shannon) gelöst. Dieses Theorem ist ein grundlegend in der Nachrichtentechnik, Signalverarbeitung und Informationstheorie. Claude Elwood Shannon formulierte es 1948 als Ausgangspunkt seiner Theorie der maximalen Kanalkapazität, d.h. der maximalen Bitrate in einem frequenzbeschränkten, rauschbelasteten Übertragungskanal. Das Abtasttheorem besagt, dass ein kontinuierliches, bandbegrenztes Signal, mit einer Minimalfrequenz von 0 Hz und einer Maximalfrequenz $f_{max}$, mit einer Frequenz f abgetastet werden muss, damit man aus dem so erhaltenen zeitdiskreten Signal das Ursprungssignal ohne Informationsverlust (aber mit unendlich großem Aufwand) exakt rekonstruieren und (mit endlichem Aufwand) beliebig genau approximieren kann. Für diese Frequenz f gilt dabei

$$f > 2 \cdot f_{max} \quad .$$

In vielen technischen kostengünstigen Anwendungen wurde vielfach eine vierfache Überabtaktung eingesetzt, respektive mit 4, jeweils um 90 Grad phasenverschobenen Takten gearbeitet.

Bei der 8B10B-Codierung werden 8-Bit-Wörter auf 10-Bit-Wörtern abgebildet. Mit der Konvertierung wird verhindert, dass sich lange Folgen von Nullen oder Einsen bilden, die auf der Empfängerseite die Taktgenerierung und Datenregenerierung erschweren. Da bei einer Umsetzung einer 8-Bit-Folge 256 Bitkombinationen entstehen, bei einer 10-Bit-Folge hingegen 1024 Bitkombinationen, nutzt man für die Abbildung der 8-Bit-Worte nur die Bitkombinationen, die viele Pegelwechsel aufweisen. Und zwar werden nur die Bitkombinationen berücksichtigt, die maximal fünf aufeinander folgende Nullen und fünf aufeinander folgende Einsen enthalten. Dadurch kann aus dem codierten Signal, das hinreichend viele Pegelwechsel aufweist, das für die Synchronisation benötigte Taktsignal abgeleitet werden.

Für die Übertragung zwischen zwei mit z.B. mit FPGA's bestückten Baugruppen mit dem standardisierten Treiberstandard LVDS [1] wird eine Übertragungsfrequenz $f_D$ von 300 MHz eingesetzt. Für die Abtastung kann weder die 4-fache Frequenz gemäss der klassischen Überabtaktung noch der Grenzwert, also die 2-fache Frequenz gemäss dem Abtasttheorem eingesetzt werden, da für kostengünstige FPGA ein vierfach schnellerer Takt ausserhalb der Spezifikation ist. Beim Einsatz von vier phasenverschobenen Takten ergibt sich eine Ungenauigkeit der Phasenlage sowie als frequenzlimitierende Elemente der Übergang der Daten von den phasenverschobenen Takten in 270°-Sprüngen auf einen gemeinsamen Takt sowie die kombinatorische Schaltung zur Selektion eines der vier Datenströme. Bei exakt zweifacher Überabtaktung ist eine Datenrückgewinnung unmöglich und bei einer dreifachen Überabtaktung kann die eindeutige Bestimmung des Datenstromes erst rückwirkend stattfinden. Der Aufwand sowie die daraus entstehende Verzögerung sind abhängig von der gewählten Datencodierung.

Das Dokument US 2003/0021299 A1 [2] beschreibt für eine digitale Datenübertragung einen Ausgleichsmechanismus, bei dem eine Mehrzahl von Signalströmen vorhanden ist, wobei für einen ersten Signalstrom die Wortausrichtung erhalten bleibt und für die weiteren die Wortausrichtung mittels einer Synchronisierungsinformation verändert wird.

In der Schrift JP 04124931 [3] ist eine Rahmensynchronisation mit folgender Wirkung offenbart: Um die Wahrscheinlichkeit zu reduzieren, dass eine Übertragung in eine pseudosynchronen Zustand zurückfällt wird ein erstes Synchronisationsmuster an einer bestimmten "timing position" gesetzt. Ein zweites Synchronisationsmuster wird pro Rahmen variabel versetzt gesetzt, wobei die variable Versetzung gemäss einer vorbestimmten Regel erfolgt.

Der Aufsatz «A chipset for gigabit rate data communication (using optical fibres» [4] beschreibt für ein digitales Übertragungsverfahren Bitkombinationen 01 und 10 als Synchronisationsinformation sowie auf der Empfängerseite eine Überabtastung.

Der vorliegenden Erfindung liegt daher die Aufgabe zugrunde ein Verfahren zur Datenübertragung von einem Sender Tx zu einem Empfänger Rx anzugeben, das beim Empfänger Rx eine Datenrückgewinnung mit einer Abtastfrequenz unwesentlich grösser als die Übertragungsfrequenz $f_D$ ermöglicht.

Diese Aufgabe wird durch die im Patentanspruch 1 angegebenen Verfahrensschritte gelöst. Vorteilhafte Ausgestaltungen der Erfindung sind in weiteren Ansprüchen angegeben.

So können sich die folgenden Vorteile zusätzlich ergeben:

i) Dadurch, dass die erste Sequenz (F) und zweite Sequenz (V) je zwei Bit (FA, FB) und (VA, VB) umfassen und die erste Sequenz (F) in ihrer Position konstant ist, während die zweite Sequenz (V) von Datenwort zu Datenwort um die feste Bitposition verschoben eingefügt wird und beide Sequenzen ein Muster mit definierten Bitwechseln beinhalten, können durch die Abtastung nicht nur die Daten zurück gewonnen werden, sondern auch der Takt.

ii) Die Datenwörter können beliebigen Ursprungs sein, also aus einem oder mehreren logischen oder physikalischen Datenströmen entstammen.

Die empfangenen Daten werden mit lediglich zwei Phasen eines leicht höheren Taktes abgetastet. Dies entspricht in etwa einer doppelten Überabtaktung.

Weil der Abtasttakt erhöht ist gegenüber dem Datentakt, verschiebt sich die Phasenlage kontinuierlich. Je nach Phasenlage wird bei steigender und fallender Taktflanke jeweils das gleiche Bit abgetastet oder ein Bit und dessen nachfolgendes Bit.

Dadurch, dass der Takt zur Abtastung in einem bekannten Teilerverhältnis p (Rho) zum Datentakt steht, kann aus der Erkennung der Abfolge zwischen den Wechseln einer gleichbittigen und wechselbittigen Abtastung die momentane Phasenlage zwischen Abtastungstakt und Daten bestimmt werden und daraus diejenige Taktflanke ermittelt werden, welche das Datenbit in optimaler Position abtastet. Das Teilerverhältnis p wird vorzugsweise bestimmt durch

$$\rho = (\Lambda_{Codewort} + 1) / \Lambda_{Codewort} ,$$

wobei $\Lambda_{Codewort}$ für die Länge eines Codeworts in Bit steht

Die nachfolgend beschriebene Rahmenbildung sorgt dafür, dass in regelmässigen Abständen Flankenwechsel auftreten, welche zur Ermittlung der Phasenlage zwischen Abtastungstakt und Daten benötigt werden.

Der beschriebene Rahmen erlaubt die Datenwortrückgewinnung, z.B. für eine nachfolgende Seriell-Parallel-Wandlung.

Die Erfindung wird nachfolgend anhand der Zeichnung beispielsweise näher erläutert. Dabei zeigt:

Figur 1 Darstellung der Signalverläufe zur Datenübertragung und Datenrückgewinnung;

Figur 2 Ausschnitt aus der Figur 1 mit der Darstellung der Abtastung E;

Figur 3 Blockschaltbild einer Übertragungseinrichtung für das erfindungsgemässe Verfahren;

Figur 4 Ausschnitt aus Figur 3 mit einer Darstellung des DDR Data Input Register des Empfängers für die Abtastung;

Figur 5 Teilblockschaltbild zur Datenrückgewinnung und Datenweitergabe mit dem Takt $CLK_{RX}$ mit Teilerverhältnis p zum nicht geregelten Takt $CLK_{XO\_Rx}$;

Figur 6 Teilblockschaltbild zur Taktrückgewinnung und Datenrückgewinnung mittels Regelung des Taktes $CLK_{VCXO\_Rx}$ und Datenweitergabe mit dem Takt $CLK_{Data\_Rx}$.

Ein erstes Ausführungsbeispiel der vorliegenden Erfindung bezieht sich auf die nachfolgend aufgeführten Tabellen 1 und 2.

Es sollen zwei synchrone Ethernet Signalströme A und B im SMII Format gemeinsam zwischen zwei FPGA's über ein LVDS Leitungspaar mit folgender Datenrate übertragen werden:

$$2 * 125 \text{ Mbit/s} = 250 \text{ Mbit/s}.$$

Ein SMII-Datenwort besteht aus 10 Bit. Die beiden Datenströme müssen für die Übertragung bitweise gemultiplext werden bilden somit zusammen ein 20 Bit langes Datenwort. Ein Codewort wird gebildet aus dem Datenwort und zusätzlichen 4 F-und V-Bits (FA, FB) und (VA, VB)

$$2x2 \text{ Bits} = 4 \text{ Bits}.$$

Das durch die 4 zusätzlichen F- und V-Bits aus dem Datenwort entstehende Codewort weist eine Länge von 24 Bit auf. Dadurch genügt die Datenrate der Übertragung folgender Beziehung:

$$(20+4)/20*2*125 \text{ Mbit/s} = 300 \text{ Mbit/s} .$$

| Bit | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 |
|---|---|---|---|---|---|---|---|---|---|---|---|---|---|---|---|---|---|---|---|---|---|---|---|---|
| N° | Codewort | | | | | | | | | | | | | | | | | | | | | | | |
| 0 | FA | FB | VA | VB | A0 | B0 | A1 | B1 | A2 | B2 | A3 | B3 | A4 | B4 | A5 | B5 | A6 | B6 | A7 | B7 | A8 | B8 | A9 | B9 |
| 1 | FA | FB | A0 | B0 | VA | VB | A1 | B1 | A2 | B2 | A3 | B3 | A4 | B4 | A5 | B5 | A6 | B6 | A7 | B7 | A8 | B8 | A9 | B9 |
| 2 | FA | FB | A0 | B0 | A1 | B1 | VA | VB | A2 | B2 | A3 | B3 | A4 | B4 | A5 | B5 | A6 | B6 | A7 | B7 | A8 | B8 | A9 | B9 |
| 3 | FA | FB | A0 | B0 | A1 | B1 | A2 | B2 | VA | VB | A3 | B3 | A4 | B4 | A5 | B5 | A6 | B6 | A7 | B7 | A8 | B8 | A9 | B9 |

Tabelle 1.1:

Einfüllen von zwei Ethernet Signalströmen A und B und von F- und V-Bits FA, FB und VA, VB zu einem Codewort.

In der Darstellung gemäss Tabelle 1.1 und der nachfolgenden Tabelle 1.2 stehen A0, A1, .., A9 für die Bits aus dem ersten Ethernet Signalstrom im SMII Format und B0, B1, .., B9 für die Bits aus dem zweiten Ethernet Signalstrom im SMII Format.

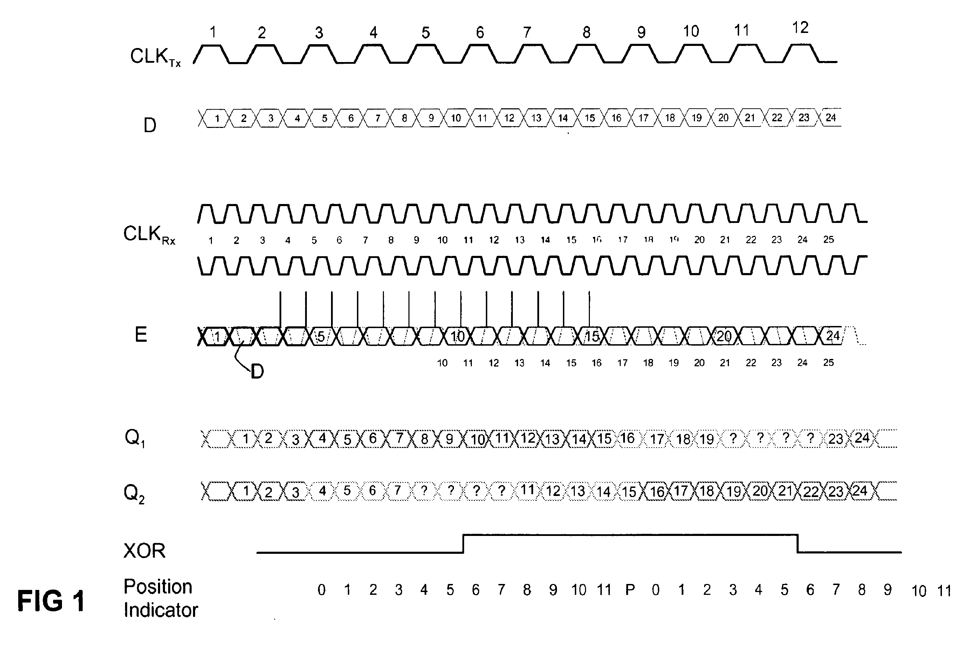

Eine erste Bitsequenz «First sequence» - nachfolgend F-Sequenz genannt - wird vor dem Datenwort von 20 Bit eingefügt: Das Bit FA wird zum Datenstrom A, das Bit FB zum Datenstrom B eingefügt. Dies erfolgt gemäss dem Blockschaltbild der Figur 1.

Eine zweite Sequenz «moVing sequence» ebenfalls bestehend aus 2 Bits pro Codewort - nachfolgend V-Sequenz genannt - verschiebt ihre Position innerhalb der Datenworte um jeweils eine Position , bestehend aus zwei Datenbits, in jedem zu übertragenden Codewort. Die erste Position der V-Sequenz liegt vor dem ersten Bit des Datenworts. Die letzte Position der V-Sequenz liegt nach dem letzten Bit des Datenworts. Bei einem Datenwort aus 2*10=20 Bits, ergeben sich somit 10+1=11 Positionen für die Einsetzung der V-Sequenz.

| Bit | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 |
|---|---|---|---|---|---|---|---|---|---|---|---|---|---|---|---|---|---|---|---|---|---|---|---|---|
| N° | Codewort | | | | | | | | | | | | | | | | | | | | | | | |
| 0 | 0 | 1 | 0 | 1 | A0 | B0 | A1 | B1 | A2 | B2 | A3 | B3 | A4 | B4 | A5 | B5 | A6 | B6 | A7 | B7 | A8 | B8 | A9 | B9 |
| 1 | 0 | 1 | A0 | B0 | 0 | 1 | A1 | B1 | A2 | B2 | A3 | B3 | A4 | B4 | A5 | B5 | A6 | B6 | A7 | B7 | A8 | B8 | A9 | B9 |
| 2 | 0 | 1 | A0 | B0 | A1 | B1 | 0 | 1 | A2 | B2 | A3 | B3 | A4 | B4 | A5 | B5 | A6 | B6 | A7 | B7 | A8 | B8 | A9 | B9 |
| 3 | 0 | 1 | A0 | B0 | A1 | B1 | A2 | B2 | 0 | 1 | A3 | B3 | A4 | B4 | A5 | B5 | A6 | B6 | A7 | B7 | A8 | B8 | A9 | B9 |

Tabelle 1.2:

Einfüllen von zwei Ethernet Signalströmen A und B und einer konkreten F- und V-Sequenz zu einem Codewort.

Gemäss der Tabelle 1.2 besteht die V-Sequenz entweder aus dem Bitmuster "01" oder "10"; also
(VA, VB) = 01 oder
(VA, VB) = 10 .
Während eines Durchlaufs von der ersten bis zur letzten Einsetzungsposition, während 11 Codewörtern, bleibt die V-Sequenz unverändert. Die Zahl 11 ergibt sich aus folgender Berechnung:

Die 2 Bit VA, VB der V-Sequenz können auf

$$((20 \text{ Nutzbits } / 2 \text{ Bits}) + 1) \text{ Arten} = 11 \text{ Arten}$$

eingefügt werden.

Beim nächsten Durchlauf, vgl. Zeilennummer N° = 11 bis 21, wenn die V-Sequenz wieder auf der ersten Position startet, wird das Bitmuster der ursprünglichen V-Sequenz invertiert.

Die F-Sequenz besteht ebenfalls entweder aus dem Bitmuster "01" oder "10", also

(FA, FB) = 01 oder

(FA, FB) = 10 .

Das Bitmuster der F-Sequenz bleibt jedoch während zweier Durchläufe der V-Sequenz unverändert und invertiert jeweils nach einem V-Sequenz Durchlauf mit dem Bitmuster "10", bevor wieder ein V-Sequenz Durchlauf mit dem Bitmuster "01" startet, siehe dazu den Wechsel von Zeilenummer N° 21 zu 22 und am Schluss von Tabelle 2 von 2eilennummer N° 43 auf 0.

Die Periodizität des Rahmens erstreckt sich in diesem Beispiel somit über 4*11=44 Daten- und Codewörter.

Aufgrund der sich verschiebenden Position der V-Sequenz kann nur in der Spalte der F-Sequenz eine Folge von 22 identischen Werten "01" oder "10" auftreten. In jeder anderen Spalte kann die Länge einer unveränderten Folge höchsten 21 werden.

| Bit | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 |
|---|---|---|---|---|---|---|---|---|---|---|---|---|---|---|---|---|---|---|---|---|---|---|---|---|
| N° | 0 | | 1 | | 2 | | 3 | | 4 | | 5 | | 6 | | 7 | | 8 | | 9 | | 10 | | 11 | |
| 0 | 0 | 1 | 0 | 1 | | | | | | | | | | | | | | | | | | | | |
| 1 | 0 | 1 | | | 0 | 1 | | | | | | | | | | | | | | | | | | |
| 2 | 0 | 1 | | | | | 0 | 1 | | | | | | | | | | | | | | | | |
| 3 | 0 | 1 | | | | | | | 0 | 1 | | | | | | | | | | | | | | |
| 4 | 0 | 1 | | | | | | | | | 0 | 1 | | | | | | | | | | | | |
| 5 | 0 | 1 | | | | | | | | | | | 0 | 1 | | | | | | | | | | |
| 6 | 0 | 1 | | | | | | | | | | | | | 0 | 1 | | | | | | | | |
| 7 | 0 | 1 | | | | | | | | | | | | | | | 0 | 1 | | | | | | |
| 8 | 0 | 1 | | | | | | | | | | | | | | | | | 0 | 1 | | | | |
| 9 | 0 | 1 | | | | | | | | | | | | | | | | | | | 0 | 1 | | |
| 10 | 0 | 1 | | | | | | | | | | | | | | | | | | | | | 0 | 1 |
| 11 | 0 | 1 | 1 | 0 | | | | | | | | | | | | | | | | | | | | |
| 12 | 0 | 1 | | | 1 | 0 | | | | | | | | | | | | | | | | | | |
| 13 | 0 | 1 | | | | | 1 | 0 | | | | | | | | | | | | | | | | |
| 14 | 0 | 1 | | | | | | | 1 | 0 | | | | | | | | | | | | | | |
| 15 | 0 | 1 | | | | | | | | | 1 | 0 | | | | | | | | | | | | |
| 16 | 0 | 1 | | | | | | | | | | | 1 | 0 | | | | | | | | | | |
| 17 | 0 | 1 | | | | | | | | | | | | | 1 | 0 | | | | | | | | |
| 18 | 0 | 1 | | | | | | | | | | | | | | | 1 | 0 | | | | | | |
| 19 | 0 | 1 | | | | | | | | | | | | | | | | | 1 | 0 | | | | |
| 20 | 0 | 1 | | | | | | | | | | | | | | | | | | | 1 | 0 | | |
| 21 | 0 | 1 | | | | | | | | | | | | | | | | | | | | | 1 | 0 |
| 22 | 1 | 0 | 0 | 1 | | | | | | | | | | | | | | | | | | | | |
| 23 | 1 | 0 | | | 0 | 1 | | | | | | | | | | | | | | | | | | |
| 24 | 1 | 0 | | | | | 0 | 1 | | | | | | | | | | | | | | | | |
| 25 | 1 | 0 | | | | | | | 0 | 1 | | | | | | | | | | | | | | |
| 26 | 1 | 0 | | | | | | | | | 0 | 1 | | | | | | | | | | | | |
| 27 | 1 | 0 | | | | | | | | | | | 0 | 1 | | | | | | | | | | |
| 28 | 1 | 0 | | | | | | | | | | | | | 0 | 1 | | | | | | | | |
| 29 | 1 | 0 | | | | | | | | | | | | | | | 0 | 1 | | | | | | |
| 30 | 1 | 0 | | | | | | | | | | | | | | | | | 0 | 1 | | | | |
| 31 | 1 | 0 | | | | | | | | | | | | | | | | | | | 0 | 1 | | |
| 32 | 1 | 0 | | | | | | | | | | | | | | | | | | | | | 0 | 1 |
| 33 | 1 | 0 | 1 | 0 | | | | | | | | | | | | | | | | | | | | |
| 34 | 1 | 0 | | | 1 | 0 | | | | | | | | | | | | | | | | | | |
| 35 | 1 | 0 | | | | | 1 | 0 | | | | | | | | | | | | | | | | |
| 36 | 1 | 0 | | | | | | | 1 | 0 | | | | | | | | | | | | | | |
| 37 | 1 | 0 | | | | | | | | | 1 | 0 | | | | | | | | | | | | |
| 38 | 1 | 0 | | | | | | | | | | | 1 | 0 | | | | | | | | | | |
| 39 | 1 | 0 | | | | | | | | | | | | | 1 | 0 | | | | | | | | |
| 40 | 1 | 0 | | | | | | | | | | | | | | | 1 | 0 | | | | | | |
| 41 | 1 | 0 | | | | | | | | | | | | | | | | | 1 | 0 | | | | |
| 42 | 1 | 0 | | | | | | | | | | | | | | | | | | | 1 | 0 | | |
| 43 | 1 | 0 | | | | | | | | | | | | | | | | | | | | | 1 | 0 |
| 0 | 0 | 1 | 0 | 1 | | | | | | | | | | | | | | | | | | | | |

Tabelle 2: Rahmen mit eingefüllter je 2 Bit langer F-Sequenz und V-Sequenz in eine Folge von Datenwörtern.

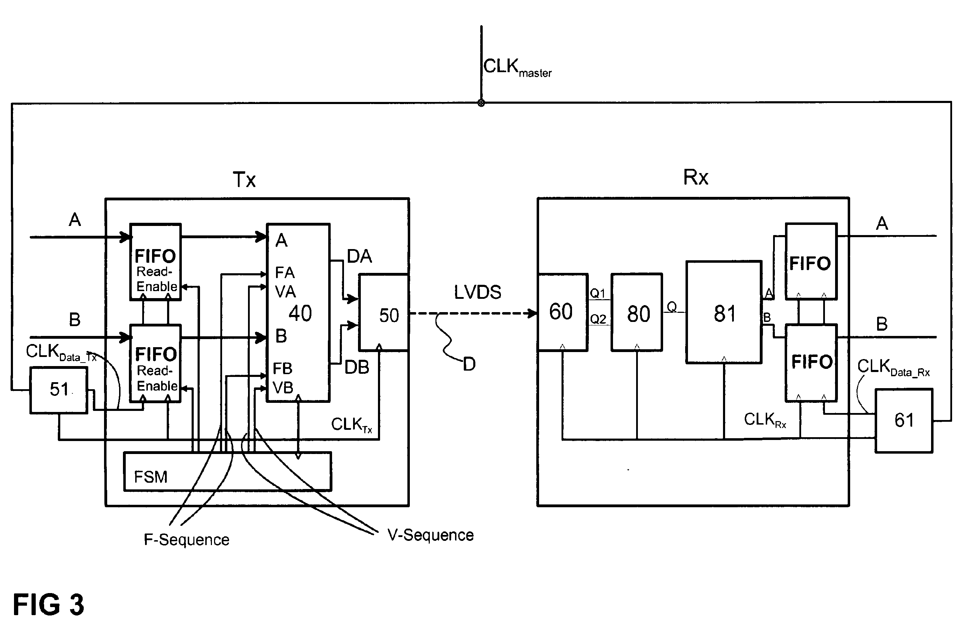

Das Blockschaltbild gemäss der Figur 3 zeigt links den Sender Tx, dem die beiden Ethernet Datenströme A und B zugeführt werden. Die beiden Datenströme A und B haben einen gemeinsamen Takt $CLK_{Data\_Tx}$. Im Gesamtsystem, zu welchem der Sender Tx und der Empfänger Rx gehören, wird ein gemeinsamer Basistakt $CLK_{Master}$ verteilt, siehe dazu je den Taktgenerator 51 für den Sender Tx und den Taktgenerator 61 für den Empfänger Rx. Der senderseitige Datentakt $CLK_{Data\_Tx}$ steht in einem festen Teilerverhältnis zum Basistakt $CLK_{Master}$. Im Multiplexer 40 des Senders Tx werden die Ethernet Ströme A und B wie oben beschrieben je mit der F- und V-Sequenz versehen. Daraus entsteht je ein codierter Signalstrom DA und DB. Diese beiden Signalströme DA und DB werden im DDR Data Output Register zu einem Signalstrom D zusammengefügt und so zum Empfänger Rx übertragen. Dieser Signalstrom D ist vorstehend mit den Tabellen 1 und 2 erklärt. Wie bei der Erklärung zu diesen Tabellen unterstellt, werden die Ethernet Datenströme dem Multiplexer 40 zugeführt und dort mit der F- und V-Sequenz FA / FB bzw. VA / VB versehen.

Entsprechend wie im Sender Tx wird der empfängerseitige Datentakt $CLK_{Data\_Rx}$ im gleichen Teilerverhältnis generiert. Aufgrund dieser Eigenschaft kann der Rahmen im Datenstrom D detektiert werden und die Datenworte zusammen mit dem Wortstart zurückgewonnen werden.

Eine zweite Eigenschaft des Rahmens ist das regelmässige Auftreten von Flanken im Datenstrom D. Diese Eigenschaft wird im Folgenden für die Phasendetektion im Empfänger ausgenutzt.

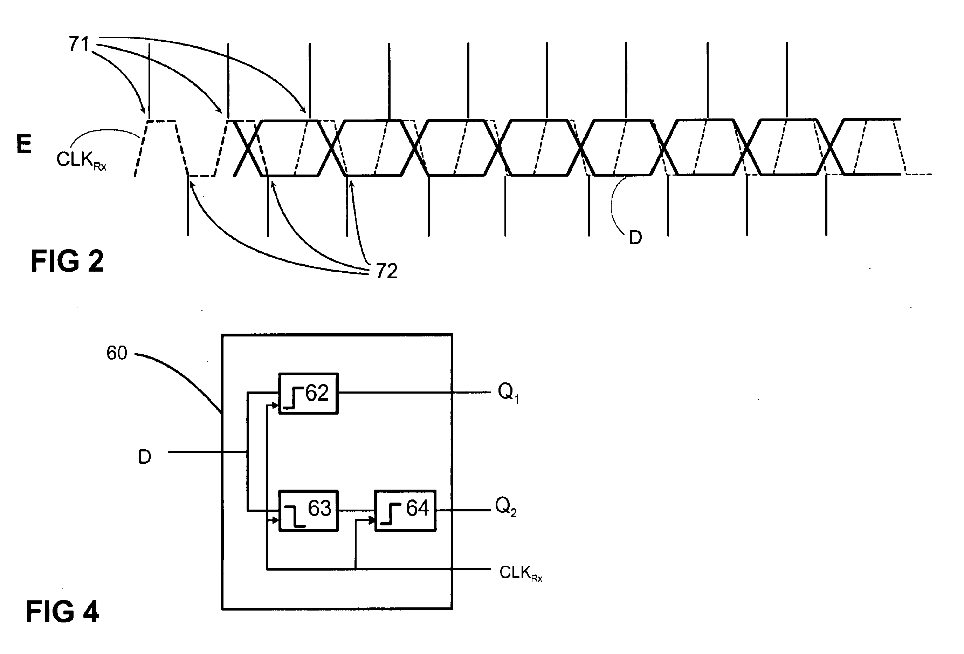

Im Empfänger Rx erfolgt die Detektion der Bitfolgen des Datenstroms im DDR Data Input Register 60, vgl. Fig. 3. Die Figur 4 ist das DDR Data Input Register mit den Flip-Flops für die Abtastung detaillierter dargestellt. Das Flip-Flop 62 detektiert den eingehenden Datenstrom D bezüglich der ansteigenden Flanke des Empfangstaktes $CLK_{Rx}$; siehe dazu die Figur 2 mit den Abtastpunkten 71 für die steigende Flanke. Das Flip-Flop 63 detektiert den eingehenden Datenstrom D bezüglich der fallenden Flanke des Empfangstaktes $CLK_{Rx}$; siehe dazu die Figur 2 mit den Abtastpunkten 72 für die steigende Flanke.

Aus dem DDR Data Input Register entstehen so zwei Bitströme Q1 und Q2, siehe dazu die Figur 1. In diesem Beispiel wird somit eine Folge von 24 Bit Übertragungsdaten eingelesen als zwei Sequenzen von jeweils 25 Bit. Das DDR-Eingangsregister 50 wird so betrieben, dass die Daten welche mit der fallenden Flanke des Empfangstakt $CLK_{RX}$ abgetastet worden sind um einen halben Takt verzögert auf die steigende Flanke des Taktes synchronisiert sind. Somit sind beide Datenströme auf die gleiche Flanke des Taktes gültig. Die weitere Verarbeitung erfolgt auf die steigende Flanke des Empfangstakt $CLK_{RX}$ mit der Frequenz

$$ f_{CLK\_Rx} \;=\; \rho \cdot f_D \;\;, $$

wobei $\rho$ das Abtastverhältnis ist mit

$$ \rho \;=\; (\Lambda_{Codewort} + 1) \; / \; \Lambda_{Codewort} \;\;. $$

$\Lambda_{Codewort}$ steht für die Länge eines Codeworts in Bit, vorliegend also der Wert 24.

Unter der Voraussetzung, dass die Daten eine minimale Augenöffnung von 50% nicht unterschreiten, kann während zwölf Takten die Daten vom Register, welches die Daten auf die steigende Flanke abtastet, übernommen werden. Anschliessend erfolgt eine Pause P von einem Bit, aufgrund der $\rho = 25/24$ Überabtastung, siehe dazu die Figur 1, wo zuunterst der Zählerstand angegeben ist. Danach können die weiteren 12 Bits vom Register übernommen werden, welches die Daten auf die fallende Flanke abtastet.

Mit einer XOR Verknüpfung (gebildet im Selektor 80) der beiden Datenströme Q1 und Q2 lässt sich feststellen, an welcher Position die steigende, respektive fallende Flanke des Taktes die Flanke der übertragenen Datenbits schneidet. Daraus lassen sich die optimalen Umschalt-Zeitpunkte bestimmen, wann die Daten des Datenstroms Q1 vom Register mit der steigenden Taktflanke und wann die Daten des Datenstroms Q2 vom Register mit der fallenden Taktflanke übernommen werden müssen. Basierend auf dem Zähler wird eine Maske festgelegt, in welchem die XOR Verknüpfung eine logische Eins ergeben kann, dass heisst Q1 und Q2 unterscheiden sich, da eine wechselbittige Abtastung stattgefunden hat. Ausserhalb der Maske repräsentieren Q1 und Q2 das gleiche Datenbit und die XOR Verknüpfung wird immer eine logische Null sein. Wenn eine wechselbittige Abtastung ausserhalb der Maske festgestellt wird, wird durch Verlängerung oder Verkürzung des Zählers die Maskenposition geregelt und damit auch die Bereiche verschoben in denen Q1 oder Q2 selektiert werden; dies erfolgt im Selektor 80 - vgl. Figur 3 im Empfänger Rx - der daraus einen Datenstrom Q bildet

Dieser Datenstrom Q wird im Demultiplexer 81 in die beiden Nutzdatenströme A und B aufgeteilt über je ein FIFO einer Anwendung zugeführt.

Für die obige Anwendung mit einer Taktrückgewinnung ist es erforderlich, dass die Bitsequenzen aus jeweils 2 Bit bestehen, um definiert Signalflanken an vorgegebenen Positionen setzen zu können. Das Ausführungsbeispiel bezieht sich auf einen Baugruppenrahmen mit einer gemeinsamen Taktversorgung CLK$_{master}$. Wird dieses Ausführungsbeispiel für eine Übertragung mit einer grösseren Distanz angewendet, steht keine gemeinsame Taktversorgung zur Verfügung. Je nach weiterer Verwendung der Daten sind dabei entweder nur die Daten zurückzugewinnen, oder die Daten und der Takt.

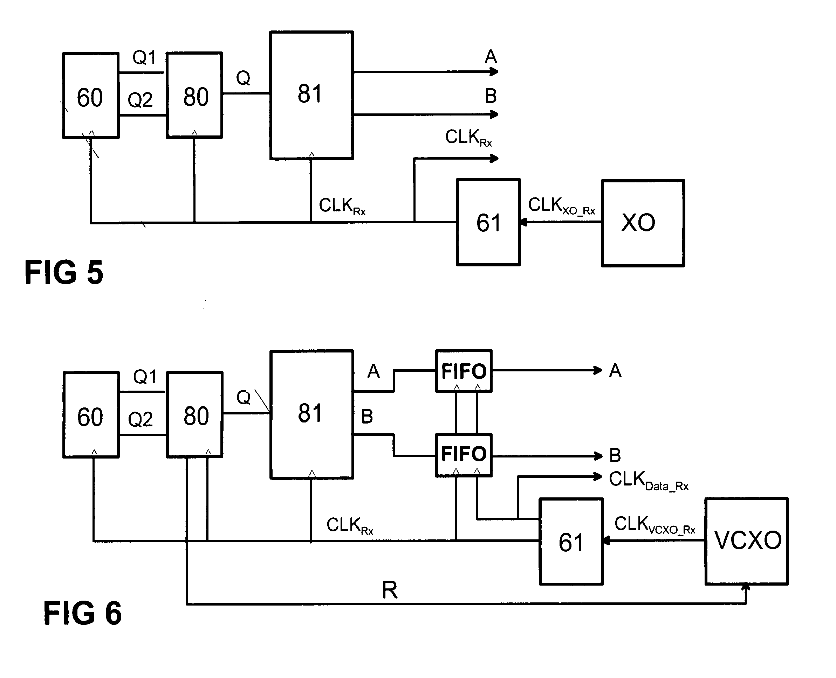

Werden die Daten mit CLK$_{RX}$ verarbeitet, erübrigt sich eine Regelung des Taktes CLK$_{XO\_Rx}$. Die Regelung findet dadurch statt, dass der Zähler, wie oben bereits beschrieben, über die Regelung der Maskenposition verkürzt oder verlängert wird. CLK$_{XO\_Rx}$ kann deshalb mit einem ungeregelten Oszillator XO erzeugt werden, siehe dazu das Teilblockschaltbild gemäss der Figur 5.

Wird zur weiteren Verwendung auch der Takt benötigt, wird im Selektor 80 anstelle der Verkürzung oder Verlängerung des Zählers ein Regelsignal R erzeugt, welches die Frequenz des Taktes CLK$_{VCXO\_Rx}$ erhöht oder verkleinert; dabei bleibt die Zählerlänge stets unverändert, der Takt CLK$_{VCXO\_Rx}$ wird dabei in einem «voltage controlled oscillator» erzeugt und dem Taktgenerator 61 zugeführt, siehe dazu das Teilblockschaltbild gemäss der Figur 6.

Wenn es aber nur darum geht, einen Rahmen für ein serielles Signal zu definieren, kann die F- und V-Bitsequenz auch nur je aus einem Bit bestehen. Dadurch verringert sich der benötigte Overhead. Die grundlegenden Eigenschaften der Eindeutigkeit und der frei wählbaren Wortlänge bleiben dabei bestehen. Das Einfügen von je nur einem F- und V-Bit wird nachfolgend beschrieben:

Die V-Sequenz invertiert nach jedem Durchlauf der Einsetzungsposition, während die F-Sequenz nur nach jedem zweiten Durchlauf invertiert.

In der nachfolgenden Tabelle ist als Beispiel ein Rahmen dargestellt für eine Wortlänge von 12 Bit: Bei einer Wortlänge von 12 Bit ergeben sich 13 Einsetzungspositionen für die V-Sequenz. Die Periodizität des Rahmens erstreckt sich in diesem Beispiel somit über 4*13=52 Datenwörter.

| Bit N° | | 0 | 1 | 2 | 3 | 4 | 5 | 6 | 7 | 8 | 9 | 10 | 11 | 12 | 13 |
|---|---|---|---|---|---|---|---|---|---|---|---|---|---|---|---|
| 0 | | 0 | 0 | | | | | | | | | | | | |
| 1 | | 0 | | 0 | | | | | | | | | | | |
| 2 | | 0 | | | 0 | | | | | | | | | | |
| 3 | | 0 | | | | 0 | | | | | | | | | |
| 4 | | 0 | | | | | 0 | | | | | | | | |
| 5 | | 0 | | | | | | 0 | | | | | | | |
| 6 | | 0 | | | | | | | 0 | | | | | | |
| 7 | | 0 | | | | | | | | 0 | | | | | |
| 8 | | 0 | | | | | | | | | 0 | | | | |
| 9 | | 0 | | | | | | | | | | 0 | | | |
| 10 | | 0 | | | | | | | | | | | 0 | | |
| 11 | | 0 | | | | | | | | | | | | 0 | |
| 12 | | 0 | | | | | | | | | | | | | 0 |
| 13 | | 0 | 1 | | | | | | | | | | | | |
| 14 | | 0 | | 1 | | | | | | | | | | | |
| 15 | | 0 | | | 1 | | | | | | | | | | |
| 16 | | 0 | | | | 1 | | | | | | | | | |
| 17 | | 0 | | | | | 1 | | | | | | | | |
| 18 | | 0 | | | | | | 1 | | | | | | | |
| 19 | | 0 | | | | | | | 1 | | | | | | |
| 20 | | 0 | | | | | | | | 1 | | | | | |
| 21 | | 0 | | | | | | | | | 1 | | | | |
| 22 | | 0 | | | | | | | | | | 1 | | | |
| 23 | | 0 | | | | | | | | | | | 1 | | |
| 24 | | 0 | | | | | | | | | | | | 1 | |
| 25 | | 0 | | | | | | | | | | | | | 1 |
| 26 | | 1 | 0 | | | | | | | | | | | | |
| 27 | | 1 | | 0 | | | | | | | | | | | |
| 28 | | 1 | | | 0 | | | | | | | | | | |
| 29 | | 1 | | | | 0 | | | | | | | | | |
| 30 | | 1 | | | | | 0 | | | | | | | | |
| 31 | | 1 | | | | | | 0 | | | | | | | |
| 32 | | 1 | | | | | | | 0 | | | | | | |
| 33 | | 1 | | | | | | | | 0 | | | | | |
| 34 | | 1 | | | | | | | | | 0 | | | | |
| 35 | | 1 | | | | | | | | | | 0 | | | |
| 36 | | 1 | | | | | | | | | | | 0 | | |
| 37 | | 1 | | | | | | | | | | | | 0 | |
| 38 | | 1 | | | | | | | | | | | | | 0 |
| 39 | | 1 | 1 | | | | | | | | | | | | |
| 40 | | 1 | | 1 | | | | | | | | | | | |
| 41 | | 1 | | | 1 | | | | | | | | | | |
| 42 | | 1 | | | | 1 | | | | | | | | | |
| 43 | | 1 | | | | | 1 | | | | | | | | |
| 44 | | 1 | | | | | | 1 | | | | | | | |
| 45 | | 1 | | | | | | | 1 | | | | | | |
| 46 | | 1 | | | | | | | | 1 | | | | | |
| 47 | | 1 | | | | | | | | | 1 | | | | |
| 48 | | 1 | | | | | | | | | | 1 | | | |
| 49 | | 1 | | | | | | | | | | | 1 | | |
| 50 | | 1 | | | | | | | | | | | | 1 | |
| 51 | | 1 | | | | | | | | | | | | | 1 |

Tabelle 3: Rahmen mit eingefüllter je 1 Bit langer F- und V- Sequenz in eine Folge von Datenwörtern.

Das vorstehende Ausführungsbeispiel ist nicht beschränkt auf die Übertragung von zwei Ethernet-Datenströmen. Die beiden Verfahren

> i) Daten- und Taktrückgewinnung mit 2-Bit-langen F- und V-Sequenzen
> oder
> ii) Serielle Datenübertragung (=Datenrückgewinnung) mit 1-Bit-langen F- und V-Sequenzen und dadurch das Auffinden des Starts eines Codewortes

können auch für mehr als zwei Datenströme oder nur einen einzigen Datenstrom auf die analoge Weise implementiert werden.

**Liste der Bezugszeichen, Glossar**

| | |
|---|---|
| 40 | Mulitplexer, Mux |
| 50 | DDR Data Output Register; DDR-Ausgangsregister |
| 51 | Taktgenerator für den Sender Tx |
| 60 | DDR Data Input Register; DDR-Eingangsregister |
| 61 | Taktgenerator für den Empfänger Rx |
| 62 | Flip-Flop auf steigende Taktflanke |
| 63 | Flip-Flop auf fallende Taktflanke |
| 64 | Flip-Flop auf steigende Taktflanke |
| 71 | Abtastpunkt für die steigende Flanke |
| 72 | Abtastpunkt für die fallende Flanke |
| 80 | Selektor |
| 81 | Demultiplexer |
| f | Frequenz |
| $f_D$ | Übertragungsfrequenz ($f_D = 2 \times F_{CLK\_Tx}$) |
| A, B | Ethernet Signalströme |
| $CLK_{Data\_Tx}$ | Senderseitiger Datentakt |
| $CLK_{Data\_Rx}$ | Empfangsseitiger Datentakt |
| $CLK_{TX}$ | Sendetakt |
| $CLK_{RX}$ | Empfangstakt |
| D | Übertragungssignal; Datenstrom |
| DA | Ethernet Signalstrom A ergänzt mit F- und V-Sequenz; codierter Signalstrom |
| DB | Ethernet Signalstrom B ergänzt mit F- und V-Sequenz |
| $f_{CLK\_Tx}$ | Sendefrequenz; codierter Signalstrom |
| $f_{CLKData\_Tx}$ | Senderseitige Datenfrequenz |
| $f_{CLK\_Rx}$ | Abtastfrequenz |
| $f_{CLKData\_Rx}$ | Empfangsseitige Datenfrequenz |
| $f_D$ | Frequenz des Übertragungssignals |
| FA | F-Bit der F-Sequenz zum Datenstrom A |
| FB | F-Bit der F-Sequenz zum Datenstrom B |
| $\Lambda_{Codewort}$ | Länge des Codeworts in Bit |
| p | Frequenzverhältnis Abtastfrequenz $f_{CLK\_Rx}$ / Übertragungsfrequenz $f_D$ |
| P | Füllbit, Pausenbit |
| DDR | Double Data Rate |
| FIFO | First-In First-Out, First-In First-Out Buffer |
| FMS | Framer State Machine |
| FPGA | Field Programmable Gate Array |
| LVDS | Low-Voltage Differential Signals LVDS |
| $Q_1, Q_2,$ | Datenstrom aus dem DDR-Eingangsregister |
| Q | Datenstrom aus dem Selektor 80 des Empfänger Rx |
| R | Regelsignal |
| Rx | Empfänger |
| SMII | Serial Media Independent Interface |
| Tx | Sender |

| VA | V-Bit der V-Sequenz zum Datenstrom A |
|---|---|
| VB | V-Bit der V-Sequenz zum Datenstrom B |
| VCXO | Voltage Controlled Oscillator |
| XO | ungeregelter Oszillator |

**Liste der zitierten Dokumente**

[1] IEEE Std 1596.3-1996 IEEE Standard for Low-Voltage Differential Signals (LVDS) for Scalable Coherent Interface (SCI) -Description

[2] US 2003/0021299 A1
«Multiplexer and Demultiplexer»
Takeshi Ota

[3] JP 04124931
«Frame synchronizing System»
Nec Corp

[4] Walker R C et al«A chipset for gigabit rate data communication (using optical fibres»Bipolar Circuits and Technology Meeting, 1989., Proceedings of the 1989Issue Date: 18-19 Sep 1989On page(s): 288 - 290

**Patentansprüche**

1. Verfahren zur digitalen Datenübertragung von einem Sender (Tx) zu einem Empfänger (Rx), wobei

   i) die zu übertragenden Daten in Datenwörter (A0, .. , A9; B0, .. , B9) gegliedert sind und im Sender ein Codewort aus zwei in das Datenwort einzufügenden Sequenzen (F, V) gebildet wird und eine Mehrzahl von Codewörtern (FA, FB, A0, B0, .. , VA, VB, .. A9 , B9) in einen Rahmen gepackt werden;
   ii) die Codewörter als Übertragungssignal (D) mit einer Übertragungsfrequenz $f_D$ zum Empfänger (Rx) übertragen werden;
   **gekennzeichnet durch** die Verfahrensschritte
   iii) die erste einzufügende Sequenz (F) wird stets am Anfang des Datenwortes (A0, B0, .. ; A9, B9) eingefügt;
   iv) die zweite einzufügende Sequenz (V) wird zuerst anschliessend an die erste Sequenz (F) eingefügt und dann von Datenwort (A0, B0, .. ; A9, B9) zu Datenwort (A0, B0, .. ,A9, B9)) um eine feste Bitposition verschoben eingefügt;
   v) in einem Input Register (60) des Empfängers (Rx) wird aus den empfangenen Codewörtern (FA, FB, A0, B0, .. , VA, VB, .. A9 , B9) aufgrund der eingefügten Sequenzen (F, V) der Rahmen detektiert mit einer Abtastfrequenz $f_{CLK\_Rx}$ mit

$$f_{CLK\_Rx} = \rho \cdot f_D \quad ,$$

wobei $\rho$ ein Abtastverhältnis von einem festen Wert ist mit

$$1 < \rho < 1.2 \ .$$

2. Verfahren nach Anspruch 1, **dadurch gekennzeichnet, dass** der feste Wert bestimmt ist durch

$$\rho = (\Lambda_{Codewort} + 1) \ / \ \Lambda_{Codewort} \quad ,$$

wobei $\Lambda_{Codewort}$ für die Länge eines Codeworts in Bit steht.

**3.** Verfahren nach Anspruch 1 oder 2,
**dadurch gekennzeichnet, dass**
im Verfahrensschritt iv) iteriert wird, wonach die zweite einzufügende Sequenz von Datenwort (A0, B0, .. ; A9, B9) zu Datenwort (A0, B0, .. , A9, B9)) um eine feste Bitposition verschoben eingefügt wird.

**4.** Verfahren nach einem der Ansprüche 1 bis 3,
**dadurch gekennzeichnet, dass**
die erste Sequenz (F) und zweite Sequenz (V) je zwei Bit (FA, FB; VA, VB) umfassen und die feste Bitposition zwei Bit beträgt.

**5.** Verfahren nach einem der Ansprüche 1 bis 3,
**dadurch gekennzeichnet, dass**
die erste Sequenz (F) und zweite Sequenz (V) je ein Bit (FA, VA) umfassen und die feste Bitposition ein Bit beträgt.

**6.** Verfahren nach einem der Ansprüche 1 bis 5,
**dadurch gekennzeichnet, dass**
die erste Sequenz (FA, FB) konstant ist, während die zweite Sequenz (VA, VB) von Datenwort zu Datenwort um die feste Bitposition verschoben eingefügt wird.

**7.** Verfahren nach einem der Ansprüche 1 bis 6,
**dadurch gekennzeichnet, dass**
die Datenwörter der zu übertragenden Daten (D) aus mehreren unabhängigen Datenströmen (A, B) gebildet werden.

**8.** Verfahren nach Anspruch 5,
**dadurch gekennzeichnet, dass**
die unabhängigen Datenströme (A, B) aus Ethernet Datenströmen (A, B) entstammen.

**9.** Übertragungssystem umfassend einen Sender (Tx) und einen Empfänger (Rx) mit Mitteln zur Durchführung des Verfahrens nach einem der Ansprüche 1 bis 8.

**10.** Übertragungssystem nach Anspruch 9,
**dadurch gekennzeichnet, dass**
Komponenten in FPGA-Technologie ausgeführt sind.

**Claims**

**1.** Method for digital transmission from a transmitter (Tx) to a receiver (Rx), wherein

i) the data to be transmitted are divided into data words (A0,.., A9; B0,.., B9) and a code word is formed in the transmitter from two sequences (F, V) to be inserted in the data word, and a plurality of a code words (FA, FB, A0, B0,.., VA, VB,.. A9, B9) are packed in a frame;
ii) the code words are transmitted to the receiver (Rx) as a transmission signal (D) at a transmission frequency $f_D$; **characterised by** the following method steps
iii) the first sequence (F) to be inserted is always inserted at the beginning of the data word (A0, B0,..; A9, B9) ;
iv) the second sequence (V) to be inserted is firstly inserted so as to follow the first sequence (F) and is then inserted shifted from data word (A0, B0,..; A9, B9) to data word (A0, B0,..; A9, B9) by a fixed bit position;
v) in an input register (60) of the receiver (Rx) the frame is detected from the received code words (FA, FB, A0, B0,.., VA, VB,.. A9, B9) on the basis of the inserted sequences (F, V) at a sampling frequency $f_{CLK\_RX}$ where

$$f_{CLK\_Rx} = \rho \cdot f_D \quad ,$$

where $\rho$ is a scanning ratio of a fixed value where

$$1 < \rho < 1.2 \ .$$

**2.** Method according to claim 1,
**characterised in that**
the fixed value is determined by

$$\rho = ( \Lambda_{codeword} + 1) / \Lambda_{codeword} \ ,$$

where $\Lambda_{codeword}$ represents the length of a code word in bits.

**3.** Method according to claim 1 or 2,
**characterised in that**
iteration takes place in method step iv), according to which the second sequence to be inserted is inserted shifted from data word (A0, B0,..; A9, B9) to data word (A0, B0,..; A9, B9) by a fixed bit position.

**4.** Method according to any one of claims 1 to 3,
**characterised in that**
the first sequence (F) and second sequence (V) comprise two bits (FA, FB; VA, VB) each and the fixed bit position is two bits.

**5.** Method according to any one of claims 1 to 3,
**characterised in that** the first sequence (F) and second sequence (V) comprise one bit (FA, VA) each and the fixed bit position is one bit.

**6.** Method according to any one of claims 1 to 5,
**characterised in that**
the first sequence (FA, FB) is constant while the second sequence (VA, VB) is inserted shifted from data word to data word by the fixed bit position.

**7.** Method according to any one of claims 1 to 6,
**characterised in that**
the data words of the data (D) to be transmitted are formed from a plurality of independent data streams (A, B).

**8.** Method according to claim 5,
**characterised in that**
the independent data streams (A, B) originate from Ethernet data streams (A, B).

**9.** Transmission system comprising a transmitter (Tx) and a receiver (Rx) with means for carrying out the method according to any one of claims 1 to 8.

**10.** Transmission system according to claim 9,
**characterised in that**
components are designed using FPGA technology.

**Revendications**

**1.** Procédé de transmission numérique de données d'un émetteur (Tx) à un récepteur (Rx), dans lequel

i) on subdivise des données à transmettre en mots (A0, ..., A9 ; B0, ..., B9) de donnée et on forme dans l'émetteur un mot de code composé de deux séquences (F, V) à ajouter au mot de donnée et on comprime en une trame une multiplicité de mots (FA, FB, A0, B0, ..., VA, VB, ....A9, B9) de code ;
ii) on transmet les mots de code comme signal (D) de transmission au récepteur (Rx) à une fréquence $f_D$ de transmission ;

**caractérisé par** les stades de procédé :

iii) on insère la première séquence (F) à insérer toujours au début du mot (A0, B0, ..., A9, B9) de donnée ;

iv) on insère la deuxième séquence (V) à insérer d'abord à la suite de la première séquence (F) et ensuite on l'insère, de manière décalée d'une position fixe de bit d'un mot (A0, B0, ..., A9, B9) de donnée, à un mot (A0, B0, ..., A9, B9) de donnée ;

v) dans un registre (60) d'entrée du récepteur (Rx) on détecte la trame sur la base des séquences (FV) insérées à partir des mots (FA, FB, A0, B0, ..., VA, VB, ....A9, B9) de code reçus à une fréquence $f_{CLK\_Rx}$ d'échantillonnage avec

$$f_{CLK\_Rx} = \rho \cdot f_D$$

$\rho$ étant un rapport d'échantillonnage d'une valeur fixe avec

$$1 < \rho < 1,2$$

2. Procédé suivant la revendication 1, **caractérisé en ce qu'**on détermine la valeur fixe par

$$\rho = (\square_{codewort} + 1) / \square_{codewort}$$

dans laquelle $\Lambda_{codewort}$ représente la longueur en bit d'un mot de code.

3. Procédé suivant la revendication 1 ou 2, **caractérisé en ce que** dans le stade de iv) du procédé on effectue une itération suivant laquelle on insère, de manière décalée d'une position de bit fixe, la deuxième séquence à insérer d'un mot (A0, B0, ..., A9, B9) de donnée à un mot (A0, B0, ..., A9, B9) de donnée.

4. Procédé suivant l'une des revendications 1 à 3, **caractérisé en ce que** la première séquence (F) et la deuxième séquence (V) comprennent respectivement deux bits (FA, FB ; VA, VB) et la positon de bit fixe est de deux bits.

5. Procédé suivant l'une des revendications 1 à 3, **caractérisé en ce que** la première séquence (F) et la deuxième séquence (V) comprennent respectivement un bit (FA, VA) et la positon de bit fixe est de un bit.

6. Procédé suivant l'une des revendications 1 à 5, **caractérisé en ce que** la première séquence (FA, FB) est constante, tandis que la deuxième séquence (VA, VB) est insérée, de manière décalée de la position de bit fixe, d'un mot de donnée à un mot de donnée.

7. Procédé suivant l'une des revendications 1 à 6, **caractérisé en ce que** l'on forme les mots de donnée (D) à transmettre de plusieurs flux (A, B) de données indépendants.

8. Procédé suivant la revendication 5, **caractérisé en ce que** les flux (A, B) de données indépendants proviennent de flux (A, B) de données d'éthernet.

9. Système de transmission comprenant un émetteur (Tx) et un récepteur (Rx) ayant des moyens pour effectuer le procédé suivant l'une des revendications 1 à 8.

10. Système de transmission suivant la revendication 9, **caractérisé en ce que** l'on réalise des composants en technologie FPGA.

FIG 1

**FIG 2**

**FIG 4**

FIG 3

FIG 5

FIG 6

EP 2 378 704 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20030021299 A1

- JP 04124931 B

**In der Beschreibung aufgeführte Nicht-Patentliteratur**

- **Walker R C et al.** A chipset for gigabit rate data communication (using optical fibres. *Bipolar Circuits and Technology Meeting, 1989., Proceedings of the 1989,* 18. September 1989, 288-290